(19) Europäisches Patentamt

European Patent Office

Office européen des brevets

(11) **EP 1 202 833 B1**

(12) **EUROPÄISCHE PATENTSCHRIFT**

(45) Veröffentlichungstag und Bekanntmachung des Hinweises auf die Patenterteilung:
**03.12.2003 Patentblatt 2003/49**

(21) Anmeldenummer: **00956215.8**

(22) Anmeldetag: **19.07.2000**

(51) Int Cl.$^7$: **B23K 26/00**, B23K 26/04, B23K 26/08, H05K 3/00

(86) Internationale Anmeldenummer:
**PCT/EP00/06914**

(87) Internationale Veröffentlichungsnummer:
**WO 01/007195 (01.02.2001 Gazette 2001/05)**

(54) **VERFAHREN ZUR ERZEUGUNG VON MIKROBOHRUNGEN**

METHOD OF PRODUCING MICROBORE HOLES

PROCEDE DE MISE EN OEUVRE DE MICROFORAGES

(84) Benannte Vertragsstaaten:
**AT BE CH CY DE DK ES FI FR GB GR IE IT LI LU MC NL PT SE**

(30) Priorität: **23.07.1999 DE 19933872**

(43) Veröffentlichungstag der Anmeldung:
**08.05.2002 Patentblatt 2002/19**

(73) Patentinhaber: **Heidelberg Instruments Mikrotechnik GmbH**
**69126 Heidelberg (DE)**

(72) Erfinder:
• **VOGLER, Sven**
**69120 Heidelberg (DE)**

• **KAPLAN, Roland**
**69126 Heidelberg (DE)**

(74) Vertreter: **Schmitt, Meinrad, Dipl.-Ing.**
**Rechts- und Patentanwälte**
**Reble & Klose**
**Bereich Patente & Marken**
**Postfach 12 15 19**
**68066 Mannheim (DE)**

(56) Entgegenhaltungen:
**EP-A- 0 884 128        US-A- 5 690 846**
**US-A- 5 751 588**

**Beschreibung**

Die Erfindung bezieht sich auf ein Verfahren zur Erzeugung von Mikrobohrungen gemäß des Oberbegriffs des Patentanspruchs 1 und ferner auf eine Vorrichtung zur Erzeugung von Mikrobohrungen gemäß des Oberbegriffs des Patentanspruchs 12.

Aus der EP-A-0 884 128 ist ein Verfahren sowie eine Vorrichtung zur Erzeugung von Mikrobohrungen der genannten Art bekannt. Hierbei ist ein Substrat auf einem XY-Tisch angeordnet, welcher entlang X- und Y-Koordinaten in die gewünschten Bearbeitungspositionen positionierbar ist, wobei mittels eines Rechnersystems die Bohrlochkoordinaten der einzubringenden Bohrungen sowie Zusatzinformationen, wie Bohrlochdurchmesser zur Verfügung gestellt werden. Um mittels eines herkömmlichen CO2-Lasers, Bohrungen mit Durchmessern von 50 $\mu$m oder kleiner herstellen zu können, wird hierbei der Laserstrahl mittels eines Telluriumkristalls in einen Strahl mit geringerer Weflenlänge umgewandelt. Eine Veränderung des Strahl- bzw. Spotdurchmessers ist nicht vorgesehen. Darüber hinaus besteht das Problem dahingehend, dass bei Erhöhung der Laserleistung zur Erzielung von größeren Bohrungsdurchmessern in Folge der Fokussierung des Laserstrahls anstelle eines zylindrischen Bohrloches eine konische Erweiterung desselben auftreten kann.

Ferner ist aus der US-A-5 690 846 ein Verfahren und eine Vorrichtung zur Bearbeitung von Substraten bekannt, mittels welchem Fehler in Folge von Verzerrungen und / oder Fehlausrichtungen des Substrats mittels besonderer Rechnerverfahren ausgeglichen werden sollen. Hinweise zur Beeinflussung des Spotdurchmessers sind nicht entnehmbar.

Der Erfindung liegt die Aufgabe zugrunde, das Verfahren und die Vorrichtung der genannten Art dahingehend weiterzubilden, dass Bohrlöcher mit unterschiedlichen Durchmessern schnell und zuverlässig erzeugt werden können.

Das Licht eines gepulsten Lasers, z.B. UV-Licht eines frequenzvervielfachten Nd-YAG-Lasers oder Infrarot-Licht eines CO2-Lasers, kann zur Erzeugung von Bohrungen in Materialien verwendet werden, welche zur Herstellung von elektronischen Leiterplatten dienen. Die Parameter der verwendeten Lichtquelle und der benutzten Optik, z. B. LaserLeistung, Pulsdauer, Spotgröße, sind allgemein bekannt. Gegenwärtige Bearbeitungssysteme bestehen grundsätzlich aus einem XY-Tisch, welcher das zu bearbeitende Substrat unter einem, den optischen Anforderungen entsprechenden, Optikaufbau positioniert. Der Optikaufbau erfüllt zwei Aufgaben: 1. Erzeugung eines intensiven gepulsten Laser-Spots zur Bearbeitung des Substrates an der geforderten Position, 2. Erkennung vorgegebener Substrat-Marken, aus vorausgegangenen Produktionsschritten, zur Bestimmung der Position. Dieser Schritt erfordert ein Bildverarbeitungssystem, bestehend aus elektronischer Kamera und einem geeignet ausgerüsteten Computersystem, welches aus den Kamerasignalen die gewünschte Positionsinformation ermittelt. Insgesamt wird die Genauigkeit der Lage der Bohrungen im Substrat, relativ zu vorgegebenen Marken, durch die Positionsgenauigkeit des Tischsystems, der Spot-Positionierungsgenauigkeit des optischen Strahlformung-Systems sowie des optischen Messsystems bestimmt. Bei modernen Leiterplatten, aufgebaut aus mehreren Lagen von Leitern und Isolationsmaterial, treten während der einzelnen Produktionsschritten Materialverzüge auf, so dass es notwendig ist, die Bohrungsmuster der individuellen Verzerrung des Grundsubstrates anzupassen. Hierzu ist wiederum eine sehr hohe Messund Positionsgenauigkeit von Tischsystem und Strahloptik erforderlich. Aus wirtschaftlichen Gründen ist es unbedingt notwendig, die Bearbeitungszeit insgesamt als auch für jede zu erstellende Bohrung so gering wie möglich zu halten. Je nach Anwendung bzw. Technologie der Leiterplatte sind Bohrungsdurchmesser von wenigen 1/10 mm bis herab zu 50 $\mu$m einzuhalten. Da der Spotdurchmesser des Laserstrahls bei typischen UV-Laserbearbeitungssystemen ca. 25 $\mu$m beträgt, müssen abweichende Bohrungsdurchmesser durch Aneinanderreihung von einzelnen Bearbeitungsschritten, im folgenden Schüsse genannt, erstellt werden. Den Materialabtrag durch mehrfaches Schießen entlang einer passend gewählten, meist spiralförmigen Bahn, nennt man "nibbling". Obwohl dieses Verfahren es erlaubt, beliebige Bohrungsdurchmesser zu erstellen, weist es den Nachteil auf, sehr zeitaufwendig zu sein. Da der Energiebedarf pro Schuss stark vom zu bearbeitenden Material abhängt, lässt sich die Bearbeitungsstrategie optimieren. Steht genügend Energie pro Laserpuls zur Verfügung, erreicht man erhebliche Durchsatzsteigerung, wenn statt des "nibbling"-Verfahrens ein geeigneter, größerer Spotdurchmesser gewählt wird und nur durch einen Schuss der erforderliche Materialabtrag für den gewünschten Bohrungsdurchmesser bewerkstelligt wird. Die Grundlage der hier neu vorgestellten Methode beruht auf der Möglichkeit, den Spotdurchmesser des zur Bearbeitung verwendeten Laserstrahls in sehr kurzer Zeit zu variieren und so Bohrbilder unterschiedlicher Durchmesser in einem Arbeitsgang zu erstellen.

Die Erfindung wird im folgenden anhand der Figuren 1 bis 10 der beigefügten Zeichnungen näher erläutert. Im einzelnen zeigen:

Fig. 1    Ein Ausführungsbeispiel einer Vorrichtung nach der Erfindung,

Fig. 2    ein Schema des Strahlenganges,

Fig. 3    ein Schema der Bildverarbeitungsbaugruppe,

Fig. 4    eine Prinzipdarstellung der in der Vorrichtung der Fig. 1 verwendeten steuerbaren Strahlaufweitung unter Verwendung von Galvanometerspiegeln,

Fig. 5    eine Prinzipdarstellung des StrahJengangs der stufenlos verstellbaren Strahlaufweitung auf der Basis aktiver Spiegelelemente,

Fig. 6    eine Prinzipdarstellung des Strahlengangs zur Vermessung und Regelung der Strahlaufweitung mittels aktiver Spiegel,

Fig. 7    eine Prinzipdarstellung der in der Vorrichtung der Fig. 1 verwendeten variablen Strahlpositionierung durch piezogetriebene verstellbare Spiegel,

Fig. 8    eine Prinzipdarstellung der in der Vorrichtung der Fig. 1 verwendeten variablen Strahlpositionierung durch akusto-optische Deflektoren,

Fig. 9    eine Prinzipdarstellung der in der Vorrichtung der Fig. 1 verwendeten variablen Strahlpositionierung durch galvanometergetriebene verstellbare Spiegel,

Fig. 10    eine Prinzipdarstellung der Steuerung der Ablenkeinheit.

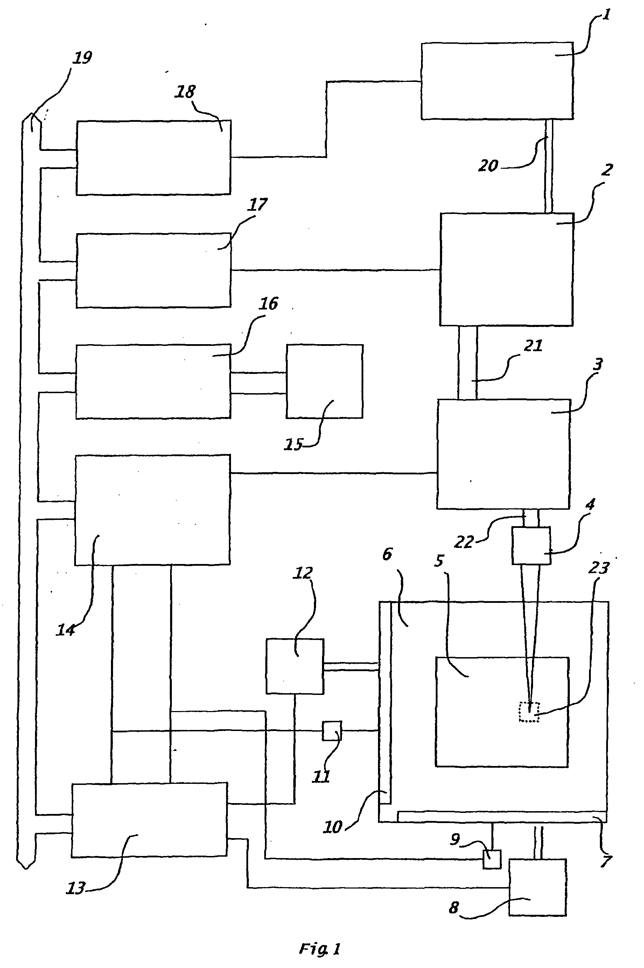

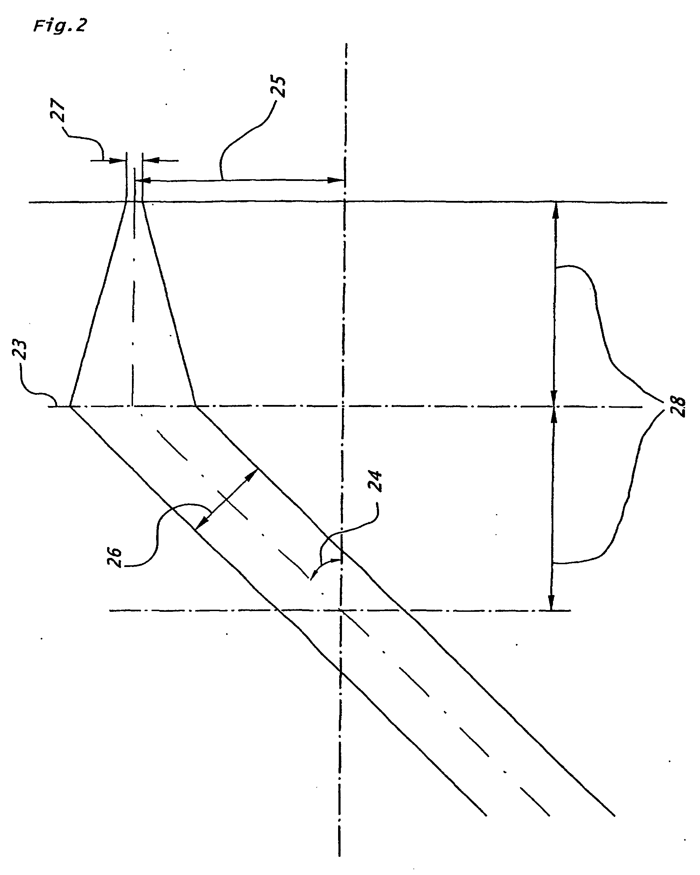

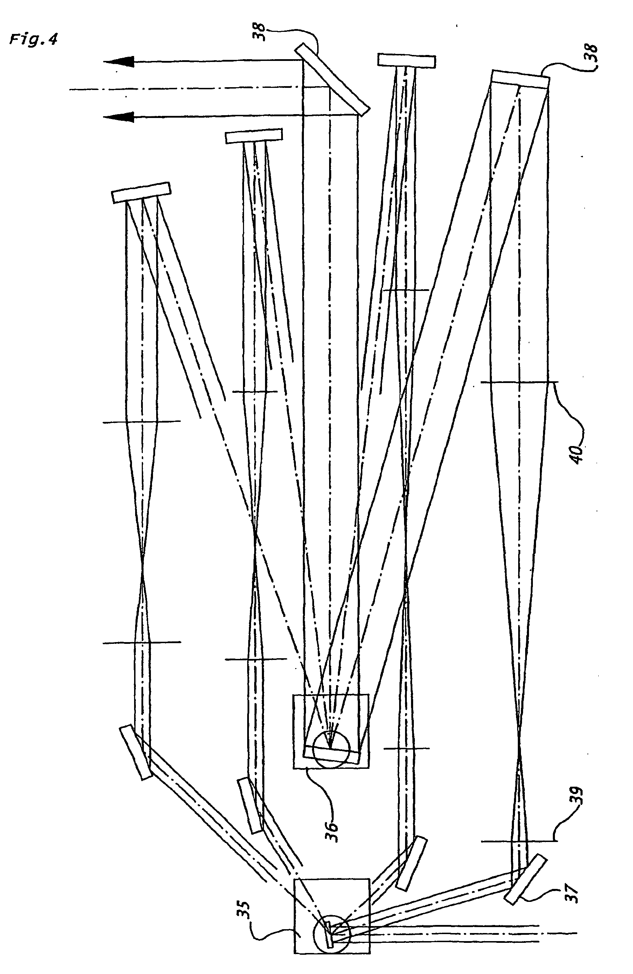

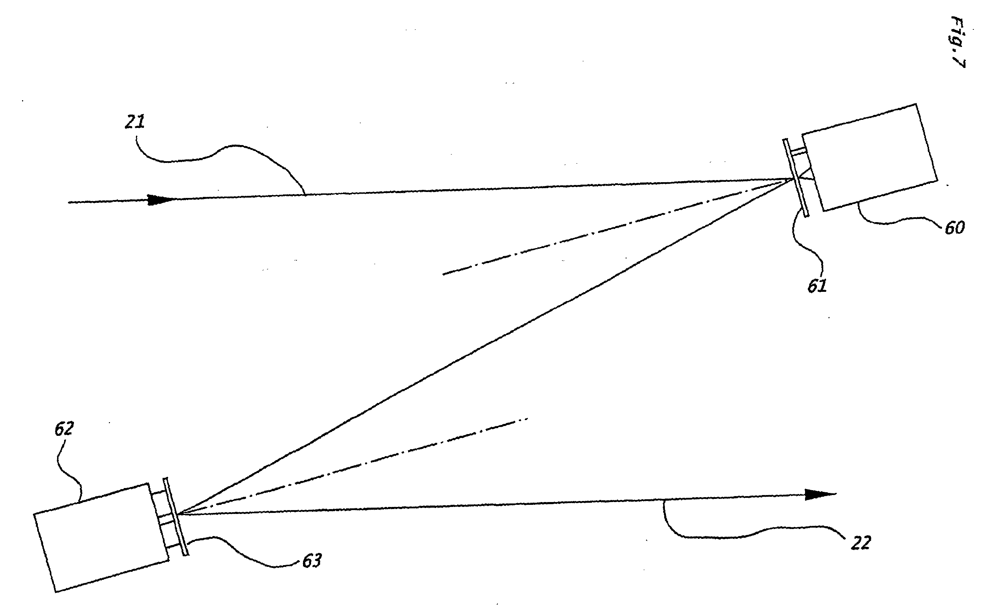

In Fig. 1 ist mit 1 ein als Lichtquelle verwendeter Laser bezeichnet, beispielsweise ein frequenzverdreifachter Nd-YAG Laser. Der Laser emittiert einen kurzen sehr kräftigen Lichtimpuls, Dauer ca. 10-20 ns, Energie ca. $10^{-4}$ Joule, sobald ein Startsignal vom Steuerrechner 16 bei der Laserelektronik 18 eintrifft. Das vom Laser emittierte Licht 20 tritt in die variable Strahlaufweitungsoptik 2 ein. Der Durchmesser des Ausgangsstrahls 21 variiert entsprechend des über die Steuereinheit 17 vom Rechner 16 eingestellten Aufweitungsverhältnisses (Details in Fig. 4, 5 bzw. Fig. 6). Das Licht, welches in die Strahlablenkeinheit 3 eintritt, wird entsprechend der Steuersignale der Kontrolleinheit 14 über zwei Ablenkeinheiten geführt ( Fig. 7, 8 und 9), so dass der austretende Strahl 22 unter veränderbaren Einfallswinkeln, separat steuerbar in X- und Y-Richtung, in das Objektiv 4 tritt. Das Objektiv 4 bildet das als ebene Welle einfallende Licht in einem Lichtfleck, im folgenden Spot genannt, auf dem zu bearbeitenden Substrat 5 ab. Die XY-Position, an welcher der Spot das Substrat 5 innerhalb des Schreibfensters 23 trifft, hängt vom Einfallswinkel in das Objektiv und der Brennweite des Objektivs ab. Wie in Verbindung mit Fig. 2 ersichtlich, kann bei kleinen Ablenkwinkeln 24 $\alpha$<8mrad eine Auslenkung 25 und damit ein Schreibfenster, gemäß

$$\delta x = \alpha * F \qquad\qquad [1]$$

von ca. 2-4 mm erreicht werden. Der Durchmesser 27 des Spots auf dem Substrat hängt vom Durchmesser 26 des einfallenden Lichtstrahls ab,

$$d = 1.21 * \lambda * F/D \qquad\qquad [2]$$

Es bedeuten hierbei:

$\delta x$ -    Spotposition relativ zum Schreibfenster
$\alpha$ -    Einfallswinkel
F -    Brennweite des Objektivs
d -    Durchmesser des Spots
$\lambda$ -    Wellenlänge des verwendeten Lichtes
D -    Durchmesser des einfallenden Strahles.

Bei geringer Strahlaufweitung erhält man einen großen Spot auf dem Substrat, bei großer Aufweitung wird das Licht stärker gebündelt, und man erhält einen kleineren Spotdurchmesser und damit kleinere Bohrungsdurchmesser im Substrat.

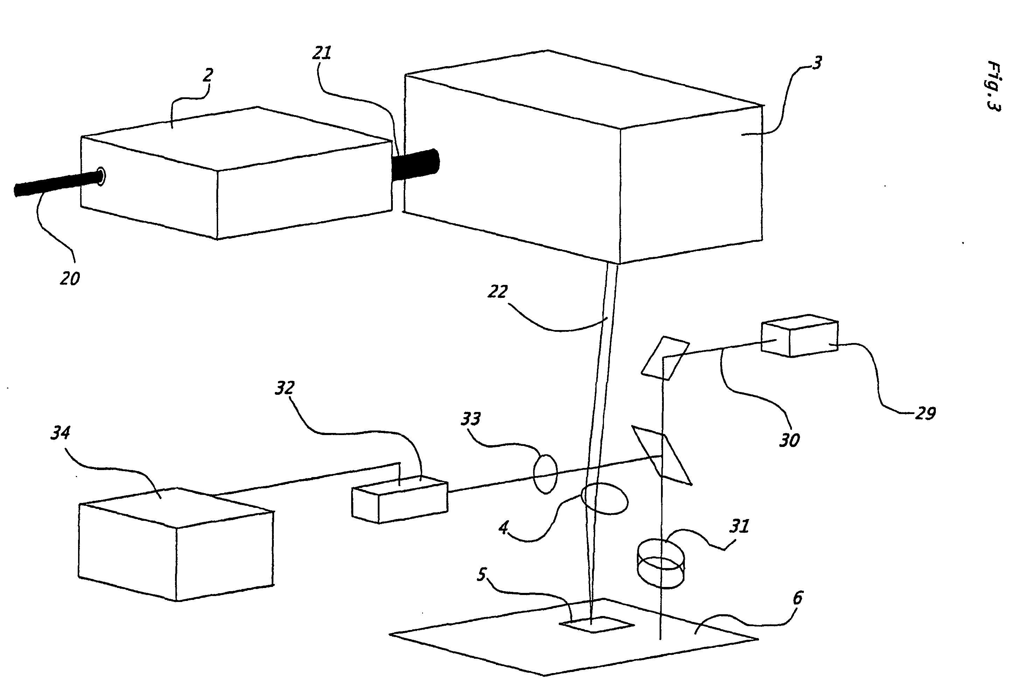

Das zu bearbeitende Substrat 5 wird auf dem XY-Tisch durch geeignete Maßnahmen, z.B. Vakuumansaugung oder Klemmvorrichtung, festgehalten. Auf gleicher Höhe wie das Substrat 5 befinden sich auf dem XY-Tisch zwei Interferrometerspiegel, nämlich ein X-Spiegel 7 und ein Y-Spiegel 10. Mit Hilfe der Interferrometer-Messköpfe, nämlich ein X-Messkopf 9 und ein Y-Messkopf 11, wird die momentane Position des XY-Tisches mit hoher Auflösung und Geschwindigkeit gemessen. Die Signale des Interferrometersystems werden sowohl der Tischpositionierelektronik 13 als auch der Strahlablenksteuerung 14 zugeführt. Die Positioniereinheit 13 steuert die Antriebseinheiten des Tisches, so dass die vom Rechner 16 vorgegebene Bahn bzw. Position erreicht wird. Abschließend sei die Bildaufnahme und Verarbeitungseinheit 15 genannt. Die Bildaufnahmeeinheit gemäß Fig. 3 entspricht der eines Auflichtmikroskops, bestehend aus einer Lichtquelle 29, einem Beleuchtungsstrahlengang 30, einem Objektiv 31 sowie der elektronischen Kamera 32 und der davor angeordneten Feldlinse 33. Die Signale der Kamera werden dem lokalen Bildverarbeitungsrechner 34 zugeführt. Der Strahlengang der Bildaufnahmeeinheit ist parallel zum Bearbeitungsstrahlengang angeordnet, so dass durch Verfahren des XY-Tisches das gesamte Substrat unter das Kameraobjektiv 31 gebracht werden kann und somit zu Vermessungszwecken dem Bildbearbeitungsrechner zur Verfügung steht.

Die Baugruppen 13 - 18 stehen untereinander über ein heterogenes Bussystem 19 in Verbindung. Die Bildverarbeitungseinheit 15 und die Steuereinheit 14 der Strahlablenkung stehen über einem parallelen Datenbus mit dem zentralen Steuerrechner 16 in Verbindung, da größere Datenmengen ausgetauscht werden sollen.

Nachfolgend wird der Ablauf des Bearbeitungsvorganges (Anspruch 2) beschrieben. Das Substrat 5, welches auf dem XY-Tisch 6 fixiert ist, wird so unter der Schreiboptik 4 positioniert, dass die Bohrlochkoordinaten innerhalb des Schreibfensters 23 liegen. Hat der XY-Tisch 6 die Koordinate $X_{Tisch}$, $Y_{Tisch}$ angefahren und besitzt die Strahlablenkeiriheit 3 in Verbindung mit dem Objektiv 4 entsprechend Gleichung [2] einen Scanbereich von $\delta x$, $\delta y$, so lassen sich alle Bohrungen der Koordinaten im Bereich

$$X_{Tisch} - \delta x < X_{Bohrung} < X_{Tisch} + \delta x$$

$$Y_{Tisch} - \delta y < Y_{Bohrung} < Y_{Tisch} + \delta y \qquad [3]$$

bearbeiten. Die Ansteuersignale für die Strahlablenkung 3 werden vom Rechner 16 aus der Bohrlochsollkoordinate und der Tischkoordinate berechnet. Beide Koordinatenwerte liegen in den Grundeinheiten des Interferrometers, im folgenden Ticks genannt, vor. Die Größe dieser Ticks hängt vom Arbeitsprinzip des Interferrometers und der Wellenlänge des verwendeten Lichtes ab. Typischerweise kommt ein HeNe-Laser, welcher Licht mit einer Wellenlänge von ca. $\lambda_{HeNe} \approx 633$ nm emittiert, zum Einsatz. Daraus ergibt sich z. B. eine Tick-Größe von ca. $\lambda_{HeNe}/16 \approx 40$ nm. Nach dem Positionierungsvorgang befindet sich der XY-Tisch an den Koordinaten

$$X_{tisch\ ist} = X_{Tisch\ soll} + \varepsilon_x$$

$$Y_{tisch\ ist} = Y_{Tisch\ soll} + \varepsilon_y \qquad [4]$$

wobei $\varepsilon_x$ und $\varepsilon_y$ den statischen Positionierfehler des Tischsystems bezeichnen.

$$X_{Ablenk} = X_{Bohrung} - X_{Tisch\ soll} - \varepsilon_x$$

$$Y_{Ablenk} = Y_{Bohrung} - Y_{Tisch\ soll} - \varepsilon_y \qquad [5]$$

Die berechneten Werte, $X_{Ablenk}$ und $Y_{Ablenk}$, kompensieren daher den Positionsfehler des Tischsystems. Das Ergebnis

$$X_{Ablenk} = X_{Bohrung} - X_{Tisch\ ist}$$

$$Y_{Ablenk} = Y_{Bohrung} - Y_{Tisch\ ist} \qquad [8]$$

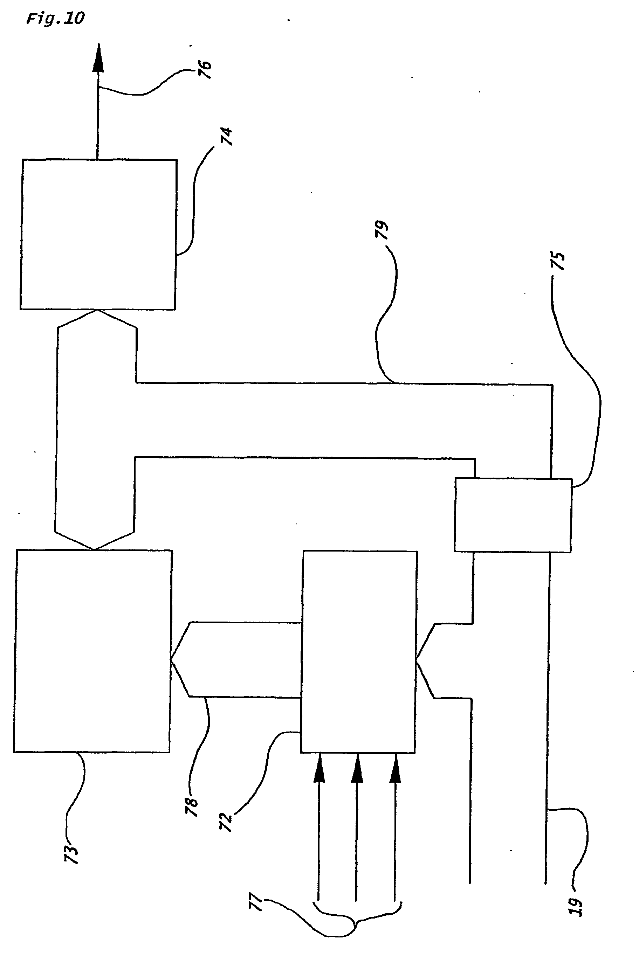

liegt zunächst als ganzzahliger Wert in Tick-Einheiten vor. Zur Ansteuerung der Strahlablenkeinheit wird jedoch im allgemeinen eine analoge Spannung, z. B. im Bereich von 0 ~ 10 Volt, benötigt, welche aus einer vom Rechner zu ladenden. Digital-Analog-Wandler-Einheit gewonnen wird. Es liegt eine feste Zuordnung von Ausgangsspannung dieser Baugruppe und dem eingeschriebenen Wert vor. Die berechneten Werte für die Strahlablenkung müssen daher umskaliert werden. Diese Skalierungsoperation erfordert zusätzliche Rechenkapazität, falls sie programmgesteuert im Rechner abläuft. Kommt ein nicht linearer Zusammenhang zwischen Ansteuerspannung der Strahlablenkeinheit und der bewirkten Ablenkung hinzu, lassen sich die benötigten Rechenoperationen nur durch einen sehr schnellen und daher unwirtschaftlichen Rechner bewerkstelligen. Aus diesem Grund (Anspruch 5) wird die Skalierungsoperation durch eine fest verdrahtete Elektronikbaugruppe innerhalb der Steuerung der Ablenkeinheit 14 durchgeführt, wie anhand von Fig. 10 erläutert. Gemäß Fig. 10 sind die Grundbaugruppen zur Ansteuerung eines Strahlablenkkanals X und Y identisch aufgebaut. In einem einmalig durchzuführenden Vorbereitungsschritt wird eine Skalierungstabelle in den Speicher 73 geladen. Der Rechner schreibt hierzu die gewünschte Adresse in den als Eingangsregister arbeitenden Vor- / Rückwärtszähler 72 und die entsprechenden Daten in die Zugriffssteuerung 75; in dieser Phase ist der D/A-Wandler 74 deaktiviert. Um die Skalierungsoperationen durchzuführen, legt der Rechner die berechneten $X_{Ablenk}$- bzw. $Y_{Ablenk}$-Werte an den Positionszähler, dessen Ausgänge den Speicher 75 adressieren. Der aus dem Speicher ausgelesene Wert wird an den Digital / Analog-Wandler 74 weitergegeben und bestimmt damit die Ansteuerspannung für die Strahlablenkeinheit 3. Für jeden möglichen Eingangswert muss im Speicher 73 ein skalierter Ausgabewert vorgehalten werden. Der Wertebereich der Ablenkwerte aus Gleichung [6] wird durch den optisch möglichen Ablenkbereich begrenzt. Geht man von einer Adressbreite von 20 bit am Speicher 73 aus, lassen sich $2^{20} \approx 1\,000\,000$ Werte ablegen. Bei einer Tickgröße von 40 nm ergibt sich ein maximaler Ablenkbereich von ca. 40 mm. Da sich der Adressbereich leicht erweitern lässt, sind Arbeitsbereiche bis über 100 mm möglich und werden praktisch nur von dem optisch Möglichen begrenzt.

Bei großflächigen Substraten ergäbe sich bei der oben beschriebenen Methode ein geringer Durchsatz, da das Tischsystem pro Bearbeitungsfeld einen Positionierungsvorgang durchführen muss. Um dies zu vermeiden, kann das Tischsystem kontinuierliche Bewegungen durchführen, wobei der nun dynamische Fehler ausgeglichen werden muss (Anspruch 3). Bei einer kontinuierlichen Tischbewegung muss der Laserspot der Substratbewegung nachgeführt werden, um mehrfach die gleiche Substratstelle bearbeiten zu können. Bewegt sich das Tischsystem mit den Geschwindigkeiten $v_x$ und $v_y$, so muss der Laserstrahl entsprechend

$$X_{Ablenk}\,(t) = X_{Bohrung} - X_{Tisch\ ist,\ T0} - v_x * t$$

$$Y_{Ablenk}\,(t) = Y_{Bohrung} - Y_{Tisch\ ist,\ T0} - v_y * t \qquad [7]$$

zeitabhängig abgelenkt, nachgeführt werden. Die Ablenkwerte setzen sich aus einem statischen Teil, der nur abhängig von der Koordinate der zu erzeugenden Bohrung ist, und einer wählbaren Tischkoordinate sowie einer von der momentanen Tischgeschwindigkeit bestimmten Komponente zusammen. In dieser Betriebsart bewegt sich der Tisch 6 und mit diesem das Substrat 5 mit einer, nicht unbedingt konstanten, Geschwindigkeit, z. B. entlang der Y-Achse. Der Rechner 16 berechnet die benötigten Ablenkwerte und vergleicht diese mit den maximal möglichen Werten. Sobald diese Werte klein genug sind, d.h. die Bohrlochkoordinaten im Bearbeitungsfenster erscheinen, wird aus Gleichung [7] der statische Teil

$$X_{Start} = X_{Bohrung} - X_{Tisch\ ist.\ T0}$$

$$Y_{Start} = Y_{Bohrung} - Y_{Tisch\ ist,\ T0} \qquad [8]$$

berechnet und in den Zähler 72 geladen. Der dynamische Fehler, v*t, wird durch Zählen der Interferometersignale im Zähler 72 kompensiert. Bei einer Tischgeschwindigkeit von z. B. 100 mm/s in Y-Richtung und einer Interferrometerauflösung, Tickgröße, von ca. 40 nm werden pro Sekunde ca. $2,5 * 10^6$ Zählsignale, bei einem mittleren zeitlichen Abstand ca. 400 ns, vom Interferrometer 11 an den Y-Zähler 72 geliefert. Der Ausgang dieses Zählers repräsentiert damit den sich ständig ändernden Ablenkwert für die Y-Achse und wird (Anspruch 5) umskaliert und zur Ansteuerung der Strahlablenkeinheit 3 verwendet. Da für beide Bewegungsachsen identisch aufgebaute Ablenksteuerungen (Fig. 10) vorhanden sind, ist die vektorielle Bewegungseinrichtung nicht eingeschränkt. Da der Zähler 72, identisch für X- und Y-Richtung, als Vor- / Rückwärtszähler ausgelegt ist, kann sowohl ein positiver als auch ein negativer dynamischer Fehler kompensiert werden. Die Bewegungsart des Tischsystems ist damit frei wählbar und kann zur Durchsatzsteigerung optimiert werden.

In der bisherigen Beschreibung der Erfindung wurde davon ausgegangen, dass die Bohrlochkoordinaten feste Werte darstellen. Da insbesondere Mehrlagen-Substrate während der Herstellung verschiedenste Prozessschritte durchlaufen müssen, ist deren Maßhaltigkeit nur bedingt gegeben. Da die Position der Bohrungen unterschiedlicher Lagen aufeinander abgestimmt sind, dürfen vorgegebene Positionstoleranzen nicht überschritten werden. Dies würde jedoch erfolgen, wenn die Bohrlochkoordinaten starr, d.h. unabhängig vom aktuell zu bearbeitenden Substrat, festgehalten würden. Wäre das Materialverhalten vollständig bekannt und wären die Prozessschritte keinen Schwankungen unterworfen, so könnten die Bohrlochkoordinaten im voraus korrigiert werden. Da jedoch Prozess- und Materialparameter Schwankungen unterworfen sind, ist eine Vorauskorrektur nur für entsprechend kleine Substrate sinnvoll. Da die Restfehler trotz Vorauskorrektur im allgemeinen proportional zur Substratgröße sind, ist ein solches Verfahren für große Substrate nicht akzeptabel. Durch eine dynamische Korrektur der Substratverzerrungen (Anspruch 4) lässt sich diese Einschränkung überwinden. Ein erster Schritt in diesem neuen Verfahren ist die Vermessung des Substrates. Auf dem Substrat müssen Markierungen, Alignmentmarken vorhanden sein, deren Sollkoordinaten bekannt sind. Diese Marken wurden z. B. im vorausgehenden Bearbeitungsschritt erstellt und müssen gegebenenfalls frei gelegt werden, um optisch mittels des Kamerasystems 15 erfassbar zu sein. Je nach Anzahl der zur Verfügung stehenden Marken lassen sich unterschiedliche Fehler bzw. Verzerrungen erfassen und somit kompensieren. Die Vermessung des Substrates bedeutet zunächst die Bestimmung der absoluten Koordinaten der Marken in Bezug auf das Tischkoordinatensystem. Hierzu positioniert der Tisch 6 das Substrat 5 derart, dass die Alignmentmarke im Blickfeld des Kamerasystems 15 erscheint. Der zugehörige Bildverarbeitungsrechner ermittelt die Koordinate relativ zum Mittelpunkt des Bildfeldes. Die absoluten Koordinaten ergeben sich aus der Addition von Bildschirmkoordinaten, d.h. skalierter Bildpunktabstand und Tischkoordinaten gemessen über die Interferrometermessköpfe 9 und 11. Durch Vermessen einer Marke wird es möglich, das benutzte Tischkoordinatensystem so zu verschieben, dass es deckungsgleich zu einem gedachten Koordinatensystem auf dem Substrat ist. Diese Deckung ist aufgrund der Substratverzerrung allerdings nur für die eine vermessende Marke gewährleistet. Durch Vermessen einer weiteren Marke und Vergleich mit deren Sollposition wird eine mögliche Verdrehung des Substrates

$$\varphi = (Y_{ist\ Mark1} - Y_{ist\ Mark1} / (X_{ist\ Mark1} - X_{ist\ Mark2}) \qquad [9]$$

zur Bewegungsrichtung des Tisches sowie eine Längenverzerrung

$$\zeta x = (X_{ist\ Mark1} - X_{ist\ Mark2}) /(X_{soll\ Mark1} - X_{soll\ Mark2}) \qquad [10]$$

in einer Achse erfasst. In den Gleichungen [9] und [10] wird davon ausgegangen, dass sich die beiden Marken auf gleicher Höhe, d.h. gleicher Y-Koordinate am linken und rechten Rand des Substrates befinden. Dies muss im allgemeinen nicht der Fall sein und verändert dieses Verfahren nicht. Es müssen jedoch die dann bekannten Versätze in X- wie in Y-Richtung in den Gleichungen einfließen. Stehen weitere Alignmentmarken zur Verfügung, dient deren Vermessung zur Ermittlung der Längenverzerrung in Y-Richtung, analog zu Gleichung [10] bzw. durch Mittelwertbildung zur Verbesserung der Messgenauigkeit.

Nachdem der erste Schritt, Parameterisierung des Auflagefehlers und Erfassung der Substratverzerrung, abgeschlossen ist, erfolgt die Kompensation dieser Effekte während des Bearbeitungsvorganges. Hierbei ist, insbesondere für Substrate, welche Mehrfachnutzen enthalten, zwischen globalen Auflagefehlern und lokalen, d.h. für jeden Nutzen getrennt bestimmbaren Parametern zu unterscheiden. Die globalen Auflagefehler werden durch Translation und Rotation des Tischkoordinatensystems kompensiert. Zur Kompensation der lokalen Verzerrungseffekte und gegebenenfalls der aufgetretenen Rotation bzw. Translation des Einzelnutzens relativ zum Gesamtsubstrat müssen die Bohrlochkoordinaten für jeden Nutzen separat transformiert werden

$$X_{Bohrung} = G_{xx} * X_{Design} + G_{xy} * Y_{Design} + G_{xz}$$

$$Y_{Bohrung} = G_{yx} * X_{Design} + Gyy * Y_{Design} + G_{yz} \qquad [11]$$

Die numerischen Werte der Transformationsparameter $G_{ij}$ berechnen sich aus den gemessenen Verzerrungsparametern.

Kern des Verfahrens nach Anspruch 4 ist, dass nach dem Erfassen sämtlicher relevanter Verzerrungsparameter die in idealen Design-Koordinaten vorliegenden Bohrlochkoordinaten während der Bearbeitungsphase in das reale Tischkoordinatensystem transformiert werden, wobei die Variation der Parameter für Mehrfachnutzen auf einem Substrat berücksichtigt wird und somit der Aufwand für Speicherplatz und anfallende Rechen- und Vergleichsoperationen minimiert wird.

Um einen wirtschaftlichen Betrieb einer Anlage entsprechend dieser Erfindung zu ermöglichen, muss der Durchsatz maximal sein, d.h. die Bearbeitungszeit pro Bohrung soll minimal sein. Der zur Erstellung der Bohrung benötigte Materialabtrag ist abhängig von der Energiedichte auf der Substratoberfläche. Bei einem relativ schwachen Laser muss der Laserstrahl stark gebündelt sein, um einen nennenswerten Abtrag zu erreichen. Das bedeutet aber auch, dass der Durchmesser des Loches bei einmaligem Auslösen des Lasers klein ist in Relation zu dem vom Design geforderten Lochdurchmesser. Das Zusammensetzen von Bearbeitungsschritten kostet sehr viel Zeit und lässt sich umgehen, wenn der Spotdurchmesser dem Bohrungsdurchmesser angepasst werden kann. Erfindungsgemäß kann die Spotgröße durch Verändern der Strahlaufweitung schnell variiert werden. In Fig. 4 ist der prinzipielle Aufbau der Anordnung zur stufenweisen Veränderung des Strahldurchmessers skizziert. Die Anordnung besteht aus paarweise angeordneten Aufweitungslinsen, deren Abstand der Summe ihrer Brennweite entspricht, so dass ein paralleles Strahlenbündel eine feste Aufweitung erfährt.

$$F1 / F2 = D1 / D2 \qquad [12]$$

Hierbei bedeuten:

F1 - Brennweite der Eingangslinse
F2 - Brennweite der Ausgangslinse
D1 - Strahldurchmesser am Eingang
D2 - Strahldurchmesser am Ausgang.

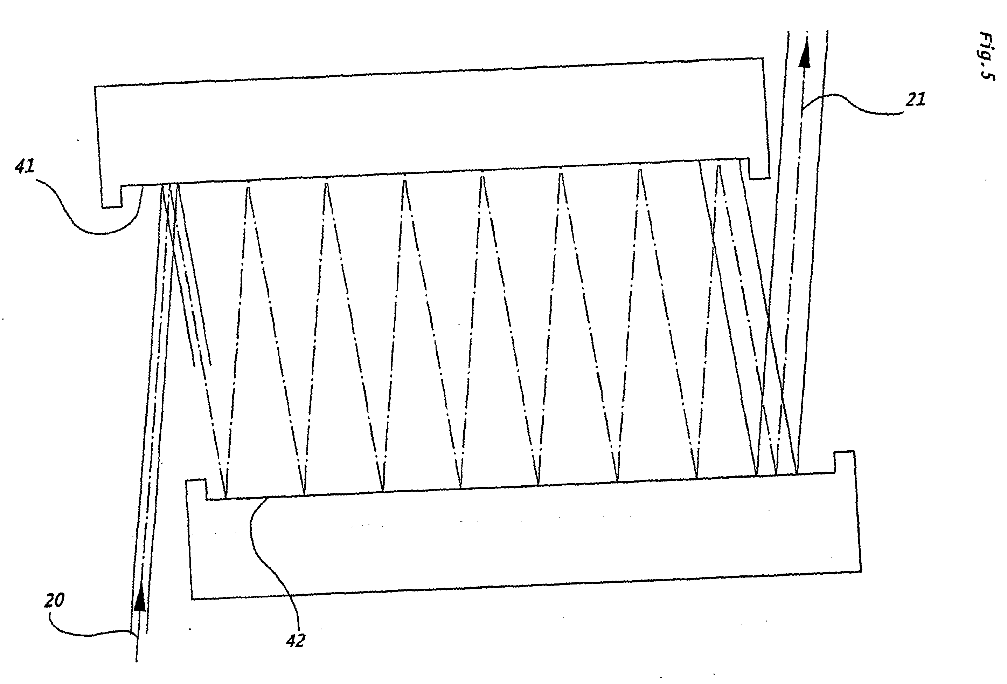

Durch Umschalten des Strahlenganges stehen mehrere feste Aufweitungen zur Auswahl. Die Umschaltung erfolgt über die Galvanometerspiegel 35 und 36. Die Hilfsspiegel sind erforderlich, um eine parallele Montage der Aufweitungslinsenpaare zu ermöglichen.
Um eine stufenlose Aufweitungsvariation zu ermöglichen, wird gemäß Fig. 5 ein weiteres optisches System eingesetzt. Es besteht aus zwei aktiven Spiegelelementen 41 und 42. Der einfallende parallele Strahl läuft nach Reflexion am konvexen Spiegel 42 auseinander. Nach Reflexion am konkaven Spiegel 41 ist er wieder parallel unter der Bedingung:

$$A = f3 + f4 \qquad [13]$$

Hierbei bedeuten:

A - Abstand der Spiegel
f3 - Brennweite des konkaven Spiegels
f4 - Brennweite des konvexen Spiegels
D3 - Strahldurchmesser vor den Spiegeln
D4 - Strahldurchmesser nach variabler Aufweitung.

Für das Verhältnis der Strahldurchmesser vor und hinter dieser Anordnung gilt, analog zu [12]:

$$F3 / f4 = D3 / D4 \qquad [14]$$

Durch einen geeignet gewählten Einfallswinkel kann erreicht werden, dass der Laserstrahl mehrfach an dem Spiegelpaar reflektiert wird. Da der Strahldurchmesser bei jedem Durchlauf gemäß Gleichung [14] erweitert wird, potenziert sich die Gesamtwirkung auf den Laserstrahl. Die Gesamtaufweitung ergibt sich zu

$$D_{aus} = D_{ein} * (f3 / f4)^N. \qquad [15]$$

Hierbei bedeuten:

$D_{aus}$ - Strahldurchmesser nach variabler Aufweitung
$D_{ein}$ - Strahldurchmesser vor variabler Aufweitung
N - Anzahl der Mehrfachreftektionen.

Wird z. B. N = 8 erreicht, genügt eine Aufweitung von ca. 10 %, d.h. D3 / D4 = f3 / f4 ≈ 1.1, um eine Gesamtaufweitung von Faktor 2 zu erreichen. In Verbindung mit einer in Potenzen von 2 abgestuften Strahlaufweitung entsprechend Fig. 4 ist eine stufenlose Wahl des Strahldurchmessers und damit der Spotgröße auf dem Substrat möglich. Die Umschaltung, d.h. die Änderung des Strahldurchmessers, erfolgt einerseits durch Verändern der Ansteuersignale für die Galvanometerdrehspiegel in der Anordnung nach Fig. 4, so dass der Laserstrahl über ein anderes Linsenpaar geführt wird. Zum anderen wird parallel gemäß Fig. 5 dazu die Ansteuerspannung des aktiven Spiegelpaares geändert.

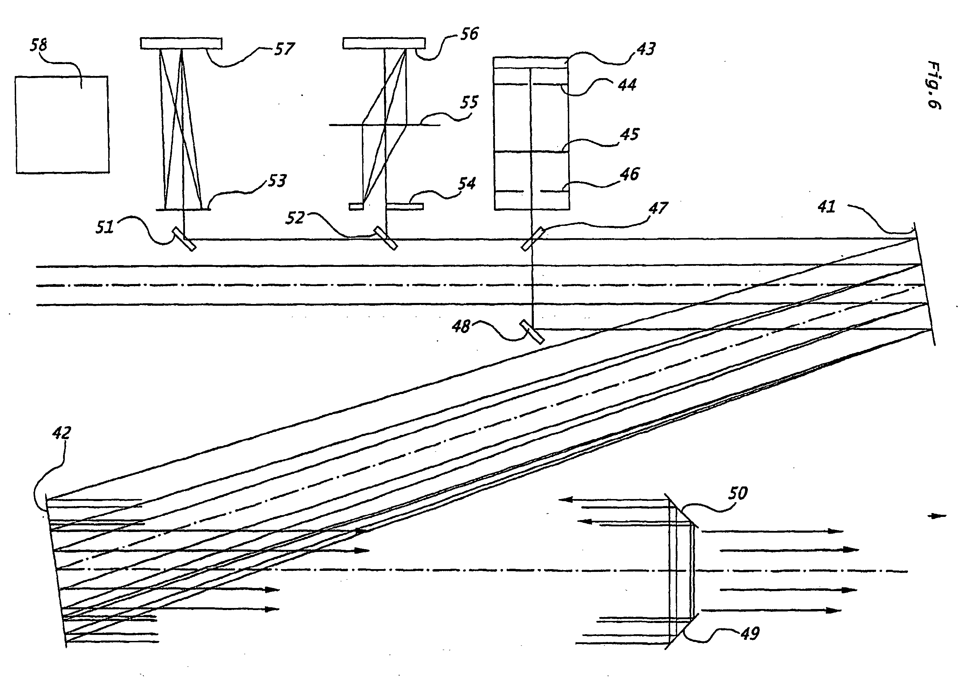

Die Brennweite eines aktiven Spiegels hängt von der angelegten Spannung sowie einigen Materialfaktoren und den gewählten Betriebsbedingungen ab. Um eine stabile und insbesondere reproduzierbare Arbeitsweise zu erhalten, kontrolliert ein Regelkreis die Steuerspannungen der aktiven Spiegel (Anspruch 8). In Fig. 6 ist der zur Vermessung der Strahlaufweitung durch die aktiven Spiegel verwendete Strahlengang gezeigt. Ausgehend von einer Lichtquelle, z.B. einem Halbleiterlaser 43, wird mit Hilfe der Lochblende 44 und einer Kolimatorlinse 45 und einer Kreisblende 46 ein paralleles Lichtbündel erzeugt. Dieses Lichtbündel wird durch den Strahlteiler bzw. Spiegel 47 in einen Referenzstrahl und einen Messstrahl aufgeteilt. Der Messstrahl wird durch den Spiegel 47 parallel zum Ausgangsstrahl über die aktiven Spiegel 41 und 42 geführt. Er durchläuft die Spiegelanordnung zweimal, da er beim Austritt durch zwei Hilfsspiegel 49 und 50 zurückgeschickt wird. Sind die aktiven Spiegel 41, 42 korrekt angesteuert, verlässt der Messstrahl diese parallel zur Einfallsachse und um einen definierten Abstand versetzt. Diese beiden Parameter werden durch Abbilden des Mess- und Referenzstrahles auf zwei Sensoren erfasst. Durch einen Strahlteiler 52 werden beide Strahlen aufgeteilt. Beide Strahlen werden einmal über den Hilfsspiegel 51 und der Kollimatorlinse 53 auf einem Zeilensensor 57 als Punkte abgebildet. Ist der Messstrahl nicht mehr parallel zum Referenzstrahl, sind die zwei Bildpunkte auf dem Zeilensensor nicht deckungsgleich. Die durch den Strahlteiler 52 angekoppelten Strahlen beleuchten eine halbkreisförmige Blende 54. Diese Blende wird mittels einer Linse 55 auf einem weiteren Zeilensensor 56 abgebildet. Aus dem Profil des Ausgangssignals dieses Sensors lässt sich der parallele Versatz von Mess- und Referenzstrahl bestimmen. Die Messsignale werden aufbereitet und dienen dem Rechner 58 als Istwertsignale, mit deren Hilfe die den geforderten Sollwerten entsprechenden Signale für die Ansteuerelektronik errechnet werden.

Den Abschluss der Beschreibung dieser Erfindung soll die Darstellung der Strahlablenkeinheit bilden. Das erfindungsgemäße Verfahren erfordert eine schnelle und genaue Strahlablenkung. Hierzu sind die im folgenden beschriebenen Verfahren geeignet.

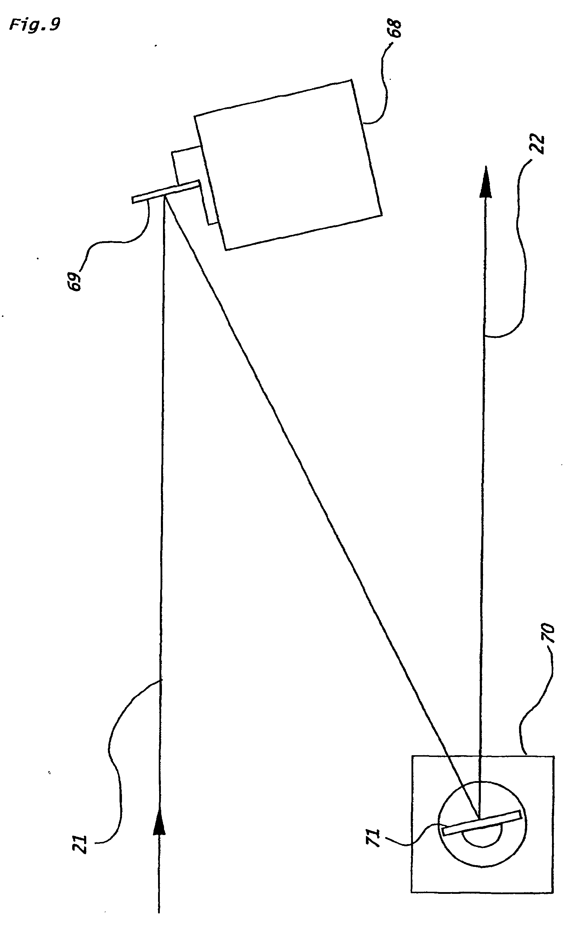

Um die notwendige Strahlablenkung durchzuführen, wird der aufgeweitete Laserstrahl über zwei senkrecht zueinander angeordnete Galvanometerspiegel (Anspruch 9) geführt, wie in Fig. 9 dargestellt. Die die Spiegelposition wiedergebenden Istwertsignale werden in der Ablenksteuerung 14 dazu verwendet, die Spiegel 69 und 71 mit Hilfe des Galvanometerantriebs 68 bzw. 70 so auszurichten, dass der statische Positionierfehler (Anspruch 2) kompensiert wird, bzw. die Spiegel so nachzuführen, dass die dynamischen Positionsfehler (Anspruch 3) verschwinden. Galvanometerspiegel erlauben einen großen Ablenkbereich, benötigen jedoch aufgrund ihrer Bauform einen großen Abstand zum Schreibobjektiv 4. Kann mit einem kleineren Ablenkwinkel gearbeitet werden, so eignen sich Piezospiegel (Anspruch 10) zur Strahlablenkung, wie in Fig. 7 dargestellt. Der Piezoantrieb 60 bzw. 62 verkippt die Scan-Spiegel 61 bzw. 63, um die benötigte Strahlablenkung zu erhalten. Bei Verwendung von 2-Achsen-Piezospiegeln lässt sich ein idealer telezentrischer Strahlengang verwirklichen.

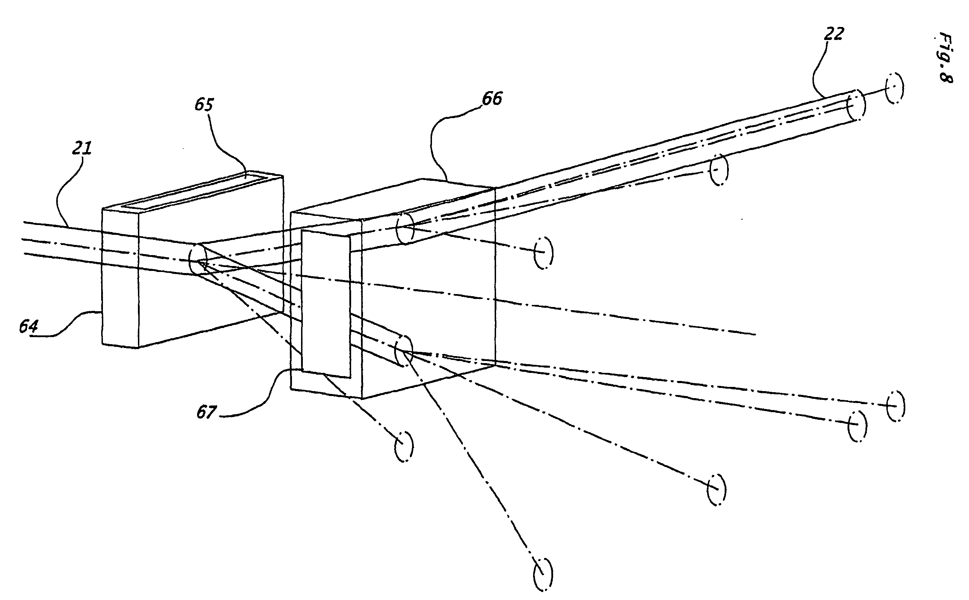

Obwohl Piezospiegel bereits deutlich schneller positionieren, ergibt sich immer noch eine deutliche Verzögerung zwischen Ausgabe der geforderten Sollposition durch den Rechner.und Erreichen der entsprechenden Istposition durch den Spiegel. Eine deutlich geringere Positionierzeit wird erreicht, wenn die Strahlablenkung durch akusto-optische Ablenker bewirkt wird (Anspruch 11), entsprechend Fig. 8. Zur Ablenkung wird im Kristall 64 bzw. 66 durch eine akustische Welle ein Beugungsgitter erzeugt. Der Ablenkwinkel ist proportional zur räumlichen Dichte des Beugungsgitters und lässt sich daher stufenlos durch Ändern der Frequenz, ca. 100 - 200 MHz, des Ansteuersignals, eingespeist über Transducer 65 bzw. 67, einstellen. Da bei diesem Verfahren nur die Füllzeit für das Kristall, ca. 30 µs bei einer Kristallgröße von ca. 20 mm und einer typischen Schallgeschwindigkeit von ca. 600 m/s, eine Zeitbeschränkung darstellt, ist diese Vorrichtung optimal geeignet, um eine schnelle und präzise Strahlablenkung zu gewährleisten.

**Bezugszeichen**

**Fig. 1:**

| | |
|---|---|
| 1 | Laser-Lichtquelle |
| 2 | Variable Strahlaufweitung |
| 3 | Ablenkeinheit |
| 4 | Objektiv |
| 5 | Substrat |
| 6 | XY-Tisch |
| 7 | X-Interferometerspiegel |
| 8 | Antriebseinheit für X-Richtung |
| 9 | X-Interferrometer |

10   Y-Interferrometerspiegel
11   Y-Interferrometer
12   Antriebseinheit für Y-Richtung
13   XY-Tischsteuerung
14   Steuerung der Ablenkeinheit
15   Elektronische Kamera inklusive Objekt und Beleuchtung
16   Rechner
17   Ansteuerung für variable Strahlaufweitung
18   Ansteuerung Laser
19   Heterogener Systembus
20   Ausgangsstrahl Laser
21   Strahl nach variabler Aufweitung
22   Scannender Strahl

**Fig. 2:**

23   Hauptebene des Objektivs
24   Einfallswinkel
25   Auslenkung
26   Durchmesser Eintrittsstrahl
27   Spotgröße
28   Brennweite des Objektivs

**Fig. 3:**

29   Lichtquelle
30   Beleuchtungsstrahlengang
31   Objektiv
32   Elektronische Kamera
33   Feldlinse
34   Bildverarbeitungsrechner

**Fig. 4:**

35   Eingangs-Gatvanometer-Drehspiegel
36   Ausgangs-Galvanometer-Drehspiegel
37   Hilfsspiegel E
38   Hilfsspiegel A
39   Aufweitungslinse E
40   Aufweitungslinse A

**Fig. 5:**

41   Aktiver Konkavspiegel
42   Aktiver Konvexspiegel

**Fig. 6:**

43   Lichtquelle, z.B. Halbleiterlaser
44   Lochblende
45   Kollimatorlinse 1
46   Kreisblende
47   Strahlteiler 30 %
48   45°-Spiegel 1
49   45°-Spiegel 2
50   45°-Spiegel 3
51   45°-Spiegel 4
52   Strahlteiler 50 %

53    Kollimatorlinse 2
54    Halbkreisblende
55    Abbildungslinse
56    Positionsdetektor 1, z.B. CCD-Zeile
57    Positionsdetektor 2, z.B. CCD-Zeile
58    Messelektronik & Rechner
59    Ansteuerelektronik für aktive Spiegel

**Fig. 7: Ablenkeinheit auf Basis von Piezo-Scanner**

60    Piezo-Scanner für X-Achse
61    Scan-Spiegel X
62    Piezo-Scanner für Y-Achse
63    Scan-Spiegel Y

**Fig. 8: Ablenkeinheit auf Basis von akusto-optischer Ablenkern**

64    AOD-Kristall zur X-Ablenkung
65    Eintrittsfläche der akustischen Welle
66    AOD-Kristall zur Y-Abtenkung
67    Eintrittsfläche der akustischen Welle

**Fig. 9: Ablenkeinheit auf Basis von Galvanometer-Scannern**

68    Galvanometer-Scanner für X-Achse
69    Scan-Spiegel
70    Galvanometer-Scanner für Y-Achse
71    Scan-Spiegel

**Fig. 10:**

72    ladbarer Vor- / Rückwärtszähler
73    Speicher
74    Digital / Analog-Wandler
75    Zugriffssteuerung
76    Sollwertspannung Ablenkeinheit
77    Interferrometer Signale
78    Adressbus
79    Datenbus

**Patentansprüche**

1.    Verfahren zur Erzeugung von Mikrobohrungen in einem mehrlagigen Substrat (5), insbesondere einem Leiterplattensubstrat, welches mittels eines XY-Tisches (6) unter einer Schreiboptik (3, 4) bewegt wird, mittels welcher ein Spot einer Lichtquelle (1), insbesondere eines Lasers, erzeugt wird, wobei gleichzeitig, den Bearbeitungspositionen entsprechend, die Position des Spots innerhalb eines Arbeitsfeldes durch elektronisch gesteuerte, bewegliche Spiegel verändert wird, wobei die Bestimmung der Substratposition durchgeführt wird und mittels eines geeignet ausgerüsteten Rechnersystems (16) die der Substratposition entsprechenden Signale zu einer ist-Position des Tischsystems verarbeitet werden und wobei dem Rechnersystem (16) vorzugsweise sämtliche Bohrlochkoordinaten sowie Zusatzinformationen, wie Bohrlochdurchmesser, insbesondere in Tabellenform, zur Verfügung gestellt werden,
      **dadurch gekennzeichnet, daß** mittels einer variablen Strahlaufweitungsoptik (2) der Durchmesser des Spots entsprechend eines mittels des Rechnersystems eingestellten Aufweitungsverhältnisses verändert wird.

2.    Verfahren nach Anspruch 1, **dadurch gekennzeichnet, daß** zur Bearbeitung einzelner Felder das Substrat (5) unter der Schreiboptik (3, 4) positioniert wird und daß statistische Positionsfehler in beiden Bewegungsachsen durch Nachführen des Spots mittels einer Strahlablenkeinheit ausgeglichen werden.

3. Verfahren nach Anspruch 1 oder 2, **dadurch gekennzeichnet, daß** das Substrat während der Bearbeitung kontinuierlich bewegt wird und der resultierende dynamische Postionsfehler in beiden Bewegungsachsen des Substrats (5) durch Nachführen des Spots mittels der Strahlablenkeinheit ausgeglichen wird.

4. Verfahren nach Anspruch 1 und 2 oder nach Anspruch 1 und 3, **dadurch gekennzeichnet, daß** zur Bearbeitung einzelner Felder oder des kontinuierlich bewegten Substrats (5) unter der Schreiboptik (4) die Bohrlochsollkoordinaten während der Bearbeitung entsprechend einer ausgemessenen Substratverzerrung korrigiert werden.

5. Verfahren nach einem der Ansprüche 1 bis 4, **dadurch gekennzeichnet, daß** mittels des Rechnersystems (16) sämtliche Koordinatenberechnungen in den Zähleinheiten des Systems zur Bestimmung der Substratposition, insbesondere des Interferrometers (9, 11) durchgeführt werden, wobei die erforderlichen Umskalierungsoperationen zur Ansteuerung der Strahlpositioniereinheit in der Schreiboptik (4) bevorzugt durch zugeordnete Speichertabellen erfolgen.

6. Verfahren nach einem der Ansprüche 1 bis 5, **dadurch gekennzeichnet, daß** mittels der Strahlaufweitungsoptik (2) der Durchmesser des Spots auf dem zu bearbeitenden Substrat (5) derart schnell verändert wird, daß unterschiedliche Bohrlochdurchmesser in einem Arbeitsgang oder mit einem einzigen Laserschuss, erstellt werden, ohne daß ein Materialabtrag durch mehrfaches Schießen entlang einer vorgegbenen Bahn erfolgt, und / oder daß in das Substrat (5) Bohrungen mit unterschiedlichen oder variierenden Durchmessern eingebracht werden, wobei entsprechend dem geforderten Bohrlochdurchmesser der Spotdurchmesser des Lichtstrahls vorgegeben wird.

7. Verfahren nach einem der Ansprüche 1 bis 6, **dadurch gekennzeichnet, daß** in der Strahlaufweitungsoptik (2) aktive Spiegelelemente zur Variation des Strahldurchmessers enthalten sind, und / oder daß die Brennweite der genannten Spiegel durch Anlegen einer Spannung geändert wird.

8. Verfahren nach Anspruch 7, **dadurch gekennzeichnet, daß** die aktiven Spiegelelemente, insbesondere mittels eines Hilfsstrahles, permanent optisch vermessen und / oder dementsprechend geregelt werden.

9. Verfahren nach einem der Ansprüche 1 bis 8, **dadurch gekennzeichnet; daß** die variable Strahlpositionierung der Schreiboptik mittels galvanometergesteuerter Drehspiegel (69, 71) erreicht wird.

10. Verfahren nach einem der Ansprüche 1 bis 8, **dadurch gekennzeichnet, daß** die variable Strahlpositionierung der Schreiboptik mittels piezogetriebener und verstellbarer Spiegel (69, 71) erreicht wird.

11. Verfahren nach einem der Ansprüche 1 bis 8, **dadurch gekennzeichnet, daß** die variable Strahlpositionierung der Schreiboptik mittels akusto-optischer Detektoren (64, 66) erreicht wird.

12. Vorrichtung zur Erzeugung von Mikrobohrungen in einem mehrlagigen Substrat (5), insbesondere einem Leiterplattensubstrat, enthaltend eine Schreiboptik (3, 4), mittels welcher ein Spot einer Lichtquelle (1), insbesondere eines Lasers, erzeugt wird, einen zur Aufnahme des Substrats (5) ausgebildeten und unter der Schreiboptik (3, 4) bewegbaren XY-Tisch (6), mittels welchem gleichzeitig, den Bearbeitungspositionen entsprechend, die Position des Spots innerhalb eines Arbeitsfeldes durch elektronisch gesteuerte, bewegliche Spiegel veränderbar ist, und ferner enthaltend ein System (7, 9, 10, 11) zur Bestimmung der Substratposition sowie ein geeignet ausgerüstetes Rechnersystems (16) zur Verarbeitung von der Substratposition entsprechenden Signalen zu einer Ist-Position des Tischsystems, wobei dem Rechnersystem (16) vorzugsweise sämtliche Bohrlochkoordinaten sowie Zusatzinformationen, wie Bohrlochdurchmesser, insbesondere in Tabellenform, zur Verfügung gestellt werden, **dadurch gekennzeichnet, daß** im Strahlengang zwichen der Lichtquelle (1) und einer Strahlablenkeinheit (3) der Schreiboptik eine variable Strahlaufweitungsoptik (2) vorgesehen ist, deren Ausgangsstrahl (21) einen entsprechend eines mittels des Rechnersystems (16) eingestellten Aufweitungsverhältnisses variierbaren Durchmesser aufweist.

13. Vorrichtung nach Anspruch 12, **dadurch gekennzeichnet, daß** das System zur Bestimmung der Substratposition ein Interferrometer mit auf dem XY-Tisch (6) in X- und Y-Richtung angeordneten X- und Y-Spiegeln (6, 7) aufweist.

14. Vorrichtung nach Anspruch 12 oder 13, welche zur Durchführung des Verfahrens nach einem der Ansprüche 2 bis 11 ausgebildet ist.

**Claims**

1. Method for producing microbore holes in a multilayer substrate (5), in particular a printed circuit board substrate, which is displaced by means of an XY stage (6) below writing optics (3, 4), by means of which a spot from a light source (1), in particular a laser, is generated, wherein the position of the spot within a working field is simultaneously changed by electronically controlled, movable mirrors in accordance with the treatment positions, the substrate position being determined and the signals corresponding to the substrate position being processed into an actual position of the stage system by means of a suitably equipped computer system (16) and preferably all hole coordinates and additional information, such as the hole diameter, being provided to the computer system (16), in particular in tabular form, **characterised in that** the diameter of the spot is changed by means of variable beam expansion optics (2) according to an expansion ratio adjusted by the computer system.

2. Method according to claim 1, **characterised in that** for the treatment of individual fields the substrate (5) is positioned below writing optics (3, 4) and **in that** statistical position errors are compensated in both movement axes by tracking the spot using a beam deflection unit.

3. Method according to claim 1 or 2, **characterised in that**, during treatment, the substrate is continuously moved and the resulting dynamic position error is compensated in both movement axes of the substrate (5) by tracking the spot by means of the beam deflection unit.

4. Method according to claims 1 and 2 or according to claims 1 and 3, **characterised in that** to treat individual fields or the continuously moved substrate (5) below the writing optics (4) the desired hole coordinates are corrected during treatment according to a measured substrate distortion.

5. Method according to any of claims 1 to 4, **characterised in that** all coordinate calculations are carried out by means of the computer system (16) in the counting units of the system to determine the position of the substrate, in particular of the interferometer (9, 11), the required rescaling operations to control the beam positioning unit in the writing optics (4) preferably being carried out by associated memory tables.

6. Method according to any of claims 1 to 5, **characterised in that**, by means of the beam expansion optics (2) on the substrate (5) to be treated, the diameter of the spot is quickly changed so that different hole diameters are set up in one operation or with a single laser pass without material being removed along a predetermined course by multiple laser passes, and/or holes with different or varying diameters are introduced into the substrate (5), the spot diameter of the light beam being determined according to the required hole diameter.

7. Method according to any of claims 1 to 6, **characterised in that** active mirror elements for varying the beam diameter are contained in the beam expansion optics (2), and/or the focal length of said mirrors is changed by applying a voltage.

8. Method according to claim 7, **characterised in that** the active mirror elements are continuously optically measured and/or accordingly regulated in particular by means of an auxiliary beam.

9. Method according to any of claims 1 to 8, **characterised in that** the variable beam positioning of the writing optics is achieved by means of galvanometrically controlled rotating mirrors (69, 71).

10. Method according to any of claims 1 to 8, **characterised in that** the variable beam positioning of the writing optics is achieved by means of piezo-driven and adjustable mirrors (69, 71).

11. Method according to any of claims 1 to 8, **characterised in that** the variable beam positioning of the writing optics is achieved by means of acousto-optical deflectors (64, 66).

12. Device for producing microbore holes in a multilayer substrate (5), in particular a printed circuit board substrate, comprising writing optics (3, 4), by means of which a spot from a light source (1), in particular a laser, is produced, an XY stage (6) designed to receive the substrate (5) and movable below the writing optics (3, 4), by means of which the position of the spot within a working field can be simultaneously changed according to the treatment positions by electronically controlled, movable mirrors, and also comprising a system (7, 9, 10, 11) for determining the substrate position as well as a suitably equipped computer system (16) for processing signals according to the substrate position into an actual position of the stage system, all hole coordinates and additional information, such as the hole diameter, preferably being provided to the computer system (16), in particular in tabular form, **characterised in that** variable beam expansion optics (2) are provided in the beam path between the light source (1) and a beam deflection unit (3) of the writing optics, the output beam (21) of the beam expansion optics (2) having a diameter which can be varied according to an expansion ratio adjusted by means of the computer system (16).

**13.** Device according to claim 12, **characterised in that** the system for determining the substrate position has an interferometer with X and Y mirrors (6, 7) arranged on the XY stage (6) in the X and Y direction.

**14.** Device according to claim 12 or 13, designed to carry out the method according to any of claims 2 to 11.

**Revendications**

**1.** Procédé pour produire des micro-perçages dans un substrat multicouche (5), en particulier un substrat de circuit imprimé, qui est déplacé au moyen d'une table XY (6) sous une optique d'écriture (3, 4) au moyen de laquelle un spot d'une source lumineuse (1), en particulier un laser, est produit, la position du spot étant modifiée simultanément à l'intérieur d'une zone de travail, de manière correspondante aux positions de traitement, par des miroirs mobiles commandés électroniquement, la détermination de la position du substrat étant effectuée et, au moyen d'un système informatique (16) équipé de manière adaptée, les signaux correspondant à la position du substrat étant transformés en une position réelle du système de table, et de préférence toutes les coordonnées du perçage ainsi que des informations complémentaires comme le diamètre du perçage étant transmises au système informatique (16), en particulier sous forme de tableau, *caractérisé en ce qu'*au moyen d'une optique d'élargissement de rayon variable (2), le diamètre du spot est modifié de manière correspondante à un rapport d'élargissement fixé au moyen du système informatique.

**2.** Procédé selon la revendication 1, *caractérisé en ce que,* pour le traitement de différentes zones, le substrat (5) est positionné sous l'optique d'écriture (3, 4), et *en ce que* des erreurs statistiques de position sur les deux axes de déplacement sont compensées par poursuite du spot au moyen d'une unité de déviation de rayon.

**3.** Procédé selon la revendication 1 ou 2, *caractérisé en ce que* le substrat est déplacé continuellement pendant le traitement et l'erreur de position dynamique en résultant est compensée sur les deux axes de déplacement du substrat (5) par poursuite du spot au moyen de l'unité de déviation de rayon.

**4.** Procédé selon la revendication 1 et 2 ou selon la revendication 1 et 3, *caractérisé en ce que,* pour le traitement de différentes zones ou du substrat (5) déplacé continuellement sous l'optique d'écriture (4), les coordonnées de consigne du perçage sont corrigées pendant le traitement de manière correspondante à une déformation de substrat mesurée.

**5.** Procédé selon l'une quelconque des revendications 1 à 4, *caractérisé en ce qu'*au moyen du système informatique (16), tous les calculs de coordonnées sont effectués dans les unités de comptage du système pour déterminer la position du substrat, en particulier de l'interféromètre (9, 11), les opérations de changement d'échelle nécessaires pour piloter l'unité de positionnement de rayon dans l'optique d'écriture (4) étant effectuées de préférence à l'aide de tables mémoire associées.

**6.** Procédé selon l'une quelconque des revendications 1 à 5, *caractérisé en ce qu'*au moyen de l'optique d'élargissement de rayon (2), le diamètre du spot sur le substrat (5) à traiter est modifié à une vitesse telle que différents diamètres de perçage sont créés dans une étape de travail ou avec un seul tir laser, sans qu'un enlèvement de matière par un tir multiple le long d'une trajectoire prédéterminée ait lieu, et/ou *en ce que* des perçages de diamètres variables ou différents sont réalisés dans le substrat (5), le diamètre de spot du rayon laser étant imposé en fonction du diamètre de perçage nécessaire.

**7.** Procédé selon l'une quelconque des revendications 1 à 6, *caractérisé en ce que* l'optique d'élargissement de rayon (2) comprend des éléments miroirs actifs pour faire varier le diamètre du rayon, et/ou *en ce que* la distance focale desdits miroirs est modifié par application d'une tension.

**8.** Procédé selon la revendication 7, *caractérisé en ce que* les éléments miroirs actifs sont mesurés optiquement en permanence, en particulier à l'aide d'un rayon auxiliaire, et/ou sont régulés de manière correspondante.

9. Procédé selon l'une quelconque des revendications 1 à 8, ***caractérisé en ce que*** le positionnement variable du rayon par l'optique d'écriture est obtenu au moyen de miroirs rotatifs galvanométriques (69, 71).

10. Procédé selon l'une quelconque des revendications 1 à 8, ***caractérisé en ce que*** le positionnement variable du rayon par l'optique d'écriture est obtenu au moyen de miroir (69, 71) mobiles et actionnés piézoélectriquement.

11. Procédé selon l'une quelconque des revendications 1 à 8, ***caractérisé en ce que*** le positionnement variable du rayon par l'optique d'écriture est obtenu au moyen de déflecteurs acoustooptiques (64 , 66).

12. Dispositif pour produire des micro-perçages dans un substrat multicouches (5), en particulier un substrat de circuit imprimé, comprenant une optique d'écriture (3, 4) au moyen de laquelle un spot d'une source lumineuse (1), en particulier un laser, est produit, une table XY (6) conformée pour recevoir le substrat (5) et mobile sous l'optique d'écriture (3, 4), au moyen de laquelle la position du spot est modifiée simultanément à l'intérieur d'une zone de travail, de manière correspondante aux positions de traitement, par des miroirs mobiles commandés électroniquement, et comprenant de plus un système (7, 9, 10, 11) pour déterminer la position du substrat ainsi qu'un système informatique (16) équipé de manière adaptée pour transformer les signaux correspondant à la position du substrat en une position réelle du système de table, de préférence toutes les coordonnées toutes les coordonnées du perçage ainsi que des informations complémentaires comme le diamètre du perçage étant transmises au système informatique (16), en particulier sous forme de tableau, ***caractérisé en ce que*** sur le trajet du rayon entre la source lumineuse (1) et une unité de déviation de rayon (3) de l'optique d'écriture est prévue une optique d'élargissement de rayon variable (2) dont le rayon de sortie présente un diamètre pouvant varier de manière correspondant à un rapport d'élargissement ajusté au moyen du système informatique (16).

13. Dispositif selon la revendication 12, ***caractérisé en ce que*** le système de détermination du substrat présente un interféromètre avec des miroirs X et Y (6, 7) placés sur la table XY (6) dans les directions X et Y.

14. Dispositif selon la revendication 12 ou 13, qui est conformé pour appliquer le procédé selon l'une quelconque des revendications 2 à 11.

Fig. 1

Fig.2

Fig.3

Fig.4

Fig.5

Fig.6

Fig.7

Fig.8

Fig.9

Fig. 10